(19) Europäisches Patentamt
European Patent Office
Office européen des brevets

(11) EP 4 625 798 A1

(12) EUROPEAN PATENT APPLICATION
published in accordance with Art. 153(4) EPC

(43) Date of publication:
01.10.2025 Bulletin 2025/40

(51) International Patent Classification (IPC):
H02M 1/42 (2007.01)  G01R 19/00 (2006.01)

(21) Application number: 23892952.5

(52) Cooperative Patent Classification (CPC):
G01R 19/00; H02M 1/00; H02M 1/08; H02M 1/42;
Y02B 70/10

(22) Date of filing: 30.03.2023

(86) International application number:
PCT/CN2023/085159

(87) International publication number:
WO 2024/108848 (30.05.2024 Gazette 2024/22)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 22.11.2022 CN 202211466215

(71) Applicant: GD Midea Air-Conditioning Equipment
Co., Ltd.
Foshan, Guangdong 528311 (CN)

(72) Inventors:
• LONG, Pengji
  Foshan, Guangdong 528311 (CN)
• SHANG, Zhiguo
  Foshan, Guangdong 528311 (CN)
• WANG, Mingming
  Foshan, Guangdong 528311 (CN)
• XU, Xinxin
  Foshan, Guangdong 528311 (CN)

(74) Representative: Ran, Handong et al
Maucher Jenkins
Seventh Floor Offices
Artillery House
11-19 Artillery Row
London SW1P 1RT (GB)

(54) CURRENT SAMPLING METHOD AND APPARATUS FOR PFC CIRCUIT, AIR CONDITIONER, AND STORAGE MEDIUM

(57) The present invention provides a current sampling method and apparatus for a PFC circuit, an air conditioner, and a storage medium. The method comprises: outputting a turn-on signal to a switching device (S 100); acquiring a first duration of the turn-on signal, and according to the first duration, determining a theoretical sampling time point for sampling an PFC circuit (S200); according to the theoretical sampling time point, acquiring a second duration within which the switching device is turned on (S300); according to the first duration and the second duration, determining a compensation duration for performing current sampling on the PFC circuit (S400); and adjusting the theoretical sampling time point according to the compensation duration to obtain a target sampling time point, and performing current sampling on the PFC circuit according to the target sampling time point (S500).

FIG. 2

# Description

## CROSS-REFERENCE TO RELATED APPLICATION

This application claims the priority of Chinese patent application No. 202211466215.3 filed on November 22, 2022, entitled "CURRENT SAMPLING METHOD AND DEVICE FOR PFC CIRCUIT, AIR CONDITIONER, AND STORAGE MEDIUM", the disclosure of which is incorporated herein by reference in its entirety.

## TECHNICAL FIELD

The present invention relates to the field of electronic control technology, and in particular to a current sampling method and device for a PFC circuit, an air conditioner, and a storage medium.

## BACKGROUND

In the related art, in a power factor correction (PFC) circuit, due to an internal resistance of a switching component, there is a delay in a turn-on signal passing through the switching component, resulting in a delay in the turn-on of the switching component. The delayed turn-on of the switching component will cause an actual sampled current to be smaller than a theoretical sampled current, leading to an error in the sampled current.

## SUMMARY

The present invention aims to at least partially solve one of the technical problems existing in the prior art. In view of this, the present invention proposes a current sampling method and device for a PFC circuit, an air conditioner, and a storage medium, which individually or collectively ensures that an actual sampled current is consistent with an expected sampled current, thereby enhancing the accuracy of the sampled current.

An embodiment in accordance with a first aspect of the present invention provides a current sampling method for a PFC circuit including a switching component, and the method includes:

- outputting a turn-on signal to the switching component;
- acquiring a first duration of the turn-on signal and determining, based on the first duration, a theoretical sampling time point for performing sampling on the PFC circuit;
- acquiring, based on the theoretical sampling time point, a second duration during which the switching component is turned on;

- determining, based on the first duration and the second duration, a compensation duration for performing current sampling on the PFC circuit; and
- adjusting the theoretical sampling time point based on the compensation duration to obtain a target sampling time point, and performing current sampling on the PFC circuit based on the target sampling time point.

The current sampling method for the PFC circuit according to this embodiment of the first aspect of the present invention has at least the following beneficial effects. By outputting the turn-on signal to the switching component, the switching component can be turned on, thereby allowing the acquisition of the first duration of the turn-on signal. Based on this first duration, the theoretical sampling time point for performing sampling on the PFC circuit can be determined. In addition, the second duration during which the switching component is turned on can be acquired based on the theoretical sampling time point. Subsequently, based on the first duration and the second duration, the compensation duration for performing current sampling on the PFC circuit can be determined. Furthermore, by adjusting the theoretical sampling time point based on the compensation duration, the delay of the turn-on signal passing through the switching component can be compensated, ensuring the consistency between the theoretical sampling time point and the actual sampling time point. Finally, current sampling on the PFC circuit can be performed based on the target sampling time point obtained by adjusting the theoretical sampling time point, ensuring that the actual sampled current is consistent with the expected sampled current, thereby enhancing the accuracy of the sampled current.

In the current sampling method for the PFC circuit, the PFC circuit further includes an inductor component configured to control charging and discharging of the inductor component, and acquiring, based on the theoretical sampling time point, a second duration during which the switching component is turned on includes:

- acquiring an accumulated charging duration of the inductor component after the theoretical sampling time point is reached; and
- defining the charging duration as the second duration during which the switching component is turned on.

By acquiring the accumulated charging duration of the inductor component after reaching the theoretical sampling time point, and defining this charging duration as the second duration during which the switching component is turned on, the compensation duration for performing current sampling on the PFC circuit can be determined based on this second duration. This allows for compensation for the delay of the turn-on signal passing through the switching component based on the compensation duration, thereby ensuring the consistency between the theoretical sampling time point and the actual sampling time point.

In the current sampling method for the PFC circuit, acquiring an accumulated charging duration of the inductor component after reaching the theoretical sampling time point includes:

- performing current sampling on the PFC circuit at the theoretical sampling time point to obtain a first sampled current;
- acquiring both an induced voltage value and an inductance value of the inductor component at the theoretical sampling time point; and
- obtaining the accumulated charging duration of the inductor component after the theoretical sampling time point is reached based on the induced voltage value, the inductance value, and the first sampled current.

By acquiring the induced voltage value and inductance value of the inductor component at the theoretical sampling time point, and by determining the accumulated charging duration of the inductor component after the theoretical sampling time point is reached based on the induced voltage value, inductance value, and first sampled current, the compensation duration for performing current sampling on the PFC circuit can be determined. This allows for compensation for the delay of the turn-on signal passing through the switching component, ensuring the consistency between the theoretical sampling time point and the actual sampling time point, thereby improving the accuracy of the sampled current in the PFC circuit.

In the current sampling method for the PFC circuit, the PFC circuit further includes an inductor component configured to control charging and discharging of the inductor component, and acquiring, based on the theoretical sampling time point, a second duration during which the switching component is turned on includes:

- acquiring a rated voltage value of the inductor component after the inductor component is charged for the first duration;
- determining a third duration required by the inductor component to be charged until a voltage value across the inductor component is equal to the rated voltage value after the turn-on signal is output to the switching component; and
- defining the third duration as the second duration during which the switching component is turned on.

By acquiring the rated voltage value of the inductor component after the inductor component is charged for the first duration, and determining the third duration required by the inductor component to be charged until the voltage value across the inductor component is equal to the rated voltage value after the turn-on signal is output to the switching component, the compensation duration for performing current sampling on the PFC circuit can be determined based on the third duration as the second duration during which the switching component is turned on. This allows for compensation for the delay of the turn-on signal passing through the switching component based on the compensation duration, thereby ensuring the consistency between the theoretical sampling time point and the actual sampling time point.

In the current sampling method for the PFC circuit, determining, based on the first duration and the second duration, a compensation duration for performing current sampling on the PFC circuit includes:

- obtaining a midpoint duration by taking half of the first duration, and subtracting the midpoint duration from the second duration to obtain a fourth duration; and
- defining the fourth duration as the compensation duration.

By subtracting half of the first duration (namely the midpoint duration) from the second duration, the compensation duration can be obtained, allowing for compensation for the delay of the turn-on signal passing through the switching component based on the compensation duration, ensuring the consistency between the theoretical sampling time point and the actual sampling time point, thereby improving the accuracy of the sampled current in the PFC circuit.

In the current sampling method for the PFC circuit, adjusting the theoretical sampling time point based on the compensation duration to obtain a target sampling time point includes:

- obtaining the target sampling time point based on a sum of the compensation duration and the theoretical sampling time point.

By summing the compensation duration and the theoretical sampling time point, the target sampling time point can be obtained, allowing for sampling at the target sampling time point to yield a sampled current equal to the theoretical sampled current, thereby ensuring that the actual sampled current is consistent with the expected sampled current.

In the current sampling method for the PFC circuit, determining, based on the first duration, a theoretical sampling time point for performing sampling on the PFC circuit includes:

- obtaining a midpoint duration by taking half of the first duration; and
- determining a midpoint time point based on the midpoint duration, and defining the midpoint time point as the theoretical sampling time point for performing sampling on the PFC circuit.

By determining the midpoint time point based on half of the first duration, the theoretical sampling time point for performing sampling on the PFC circuit can be determined, facilitating the acquisition of the second duration during which the switching component is turned on based on the theoretical sampling time point. This allows for the determination of the compensation duration for performing current sampling on the PFC circuit based on the second duration, compensating for the delay of the turn-on signal passing through the switching component, ensuring the consistency between the theoretical sampling time point and the actual sampling time point, and thereby enhancing the accuracy of the sampled current.

In the current sampling method for the PFC circuit, after performing current sampling on the PFC circuit based on the target sampling time point, the method further includes:

- acquiring a second sampled current obtained by performing current sampling on the PFC circuit at the target sampling time point; and
- acquiring a bus voltage of the PFC circuit, and adjusting the first duration based on the second sampled current and the bus voltage.

By adjusting the theoretical sampling time point and performing current sampling on the PFC circuit based on the adjusted theoretical sampling time point, the second sampled current obtained by performing current sampling on the PFC circuit at the target sampling time point can be acquired, which means that the actual sampled current is equal to the theoretical sampled current. Then, by acquiring the bus voltage of the PFC circuit, the first duration can be adjusted based on the second sampled current and the bus voltage, ensuring that all subsequent sampled currents are consistent with the expected sampled current, thereby enhancing the accuracy of the sampled current.

An embodiment in accordance with a second aspect of the present invention provides a current sampling device, which includes a memory, at least one processor, and a computer program stored in the memory and executable by the processor. The computer program, when executed by the processor, causes the processor to implement the current sampling method for the PFC circuit as described in the first aspect.

The current sampling device, according to the embodiment of the second aspect of the present invention, has at least the following beneficial effects. By outputting the turn-on signal to the switching component, the switching component can be turned on, thereby allowing the acquisition of the first duration of the turn-on signal. Based on this first duration, the theoretical sampling time point for performing sampling on the PFC circuit can be determined. Next, the second duration during which the switching component is turned on can be acquired based on the theoretical sampling time point. Then, based on the first duration and the second duration, the compensation duration for performing current sampling on the PFC circuit can be determined. Furthermore, by adjusting the theoretical sampling time point based on the compensation duration, the delay of the turn-on signal passing through the switching component can be compensated, ensuring the consistency between the theoretical sampling time point and the actual sampling time point. Finally, current sampling on the PFC circuit can be performed based on the target sampling time point obtained by adjusting the theoretical sampling time point, ensuring that the actual sampled current is consistent with the expected sampled current, thereby enhancing the accuracy of the sampled current.

An embodiment in accordance with a third aspect of the present invention provides an air conditioner, including the current sampling device as described in the second aspect.

The air conditioner, according to the embodiment of the present invention, has at least the following beneficial effects. By outputting the turn-on signal to the switching component, the switching component can be turned on, thereby allowing the acquisition of the first duration of the turn-on signal. Based on this first duration, the theoretical sampling time point for performing sampling on the PFC circuit can be determined. Next, the second duration during which the switching component is turned on can be acquired based on the theoretical sampling time point. Then, based on the first duration and the second duration, the compensation duration for performing current sampling on the PFC circuit can be determined. Furthermore, by adjusting the theoretical sampling time point based on the compensation duration, the delay of the turn-on signal passing through the switching component can be compensated, ensuring the consistency between the theoretical sampling time point and the actual sampling time point. Finally, current sampling on the PFC circuit can be performed based on the target sampling time point obtained by adjusting the theoretical sampling time point, ensuring that the actual sampled current is consistent with the expected sampled current, thereby enhancing the accuracy of the sampled current.

An embodiment in accordance with a fourth aspect of the present invention provides a computer-readable storage medium, storing computer-executable instructions configured to cause a computer to implement the current sampling method of the PFC circuit as described in the embodiment of the first aspect.

The computer-readable storage medium according to the embodiment of the present invention has at least the following beneficial effects. By outputting the turn-on signal to the switching component, the switching component can be turned on, thereby allowing the acquisition of the first duration of the turn-on signal. Based on this first duration, the theoretical sampling time point for performing sampling on the PFC circuit can be determined. Next, the second duration during which the switching component is turned on can be acquired based on the theoretical sampling time point. Then, based on the first duration and the second duration, the compensation duration for performing current sampling on the PFC circuit can be determined. Furthermore, by adjusting the theoretical sampling time point based on the compensation duration, the delay of the turn-on signal passing through the switching component can be compensated, ensuring the consistency between the theoretical sampling time point and the actual sampling time point. Finally, current sampling on the PFC circuit can be performed based on the target sampling time point obtained by adjusting the theoretical sampling time point, ensuring that the actual sampled current is consistent with the expected sampled current, thereby enhancing the accuracy of the sampled current.

Additional features and advantages of the present invention will be set forth in the subsequent description, and in part will become apparent from the description, or may be learned by practice of the present invention. The objectives and other advantages of the present invention can be realized and obtained by structures specified in the description, the claims and the accompanying drawings.

## BRIEF DESCRIPTION OF DRAWINGS

The present invention will be further explained hereinafter with reference to the accompanying drawings and embodiments.

FIG. 1 is a schematic diagram of a PFC circuit according to an embodiment of the present invention;
FIG. 2 is a flowchart of a current sampling method for a PFC circuit according to an embodiment of the present invention;
FIG. 3 is a schematic diagram of an arrangement of current sampling points according to an embodiment of the present invention;
FIG. 4 is a specific flowchart of step S300 in FIG. 2;
FIG. 5 is a specific flowchart of step S310 in FIG. 4;
FIG. 6 is another specific flowchart of step S300 in FIG. 2;
FIG. 7 is a specific flowchart of step S400 in FIG. 2;
FIG. 8 is a specific flowchart of step S200 in FIG. 2;
FIG. 9 is a flowchart of a current sampling method of a PFC circuit according to another embodiment of the present invention;
FIG. 10 is a schematic diagram of current waveforms of sampled currents according to an embodiment of the present invention;
FIG. 11 is a schematic diagram of current waveforms of sampled currents according to another embodiment of the present invention; and
FIG. 12 is a schematic diagram of a current sampling device according to an embodiment of the present invention.

## DETAILED DESCRIPTION

This section will describe specific embodiments of the present invention in detail, and preferred embodiments of the present invention are shown in the accompanying drawings. The accompanying drawings are used to supplement the text description of the specification with graphic illustrations, so that each technical feature and the overall technical scheme of the present invention can be intuitively and vividly understood. However, the accompanying drawings should not be construed as limiting the scope of protection of the present invention.

It should be understood that, in the description of the embodiments of the present invention, if "first" and "second", etc. are referred to, it is only for the purpose of distinguishing technical features, and shall not be understood as indicating or implying relative importance or implying the number of the indicated technical features or implying the sequence of the indicated technical features. "At least one" means one or more, and "a plurality of" means two or more. The term "and/or" describes an association relationship of associated objects, and represents that there may be three kinds of relationships. It can be understood that A and/or B may represent three cases: only A exists, both A and B exist, and only B exists. A and B may be singular or plural. The character "/" generally indicates an "or" relationship between associated objects before and after the character. "At least one of" and a similar expression means any combination of the items, including a single item or any combination of a plurality of items. For example, at least one of a, b, and c may indicate: a, b, c, a and b, a and c, b and c, or a and b and c, where a, b, or c may be singular or plural.

It should also be noted that if there are directional indications in the embodiments of the present invention, such as up, down, left, right, front, back, etc., these directional indications are only used to explain the relative positional relationships between various components and the motion conditions in a specific posture (for example, as shown in the drawings), etc., and if the specific posture changes, the directional indications should also change accordingly. Furthermore, unless otherwise expressly specified and defined, the term "connect/couple" is to be understood broadly, which, for example, may mean a fixed or movable connection, a detachable or non-detachable connection, or an integral connection; may mean a mechanical connection or an electrical connection or communication with each other; and may mean a direct connection, or an indirect connection by means of an intermediate medium.

In the description of the embodiments of the present invention, the description with reference to the terms "an embodiment/implementation", "another embodiment/implementation", "some embodiments/implementations", "in the above embodiment/implementation", and the like means that specific features, structures, materials, or characteristics described in connection with the embodiment or example are included in at least two embodiments or implementations of the present invention. In the present invention, the illustrative expressions of the aforementioned terms do not necessarily refer to the same embodiment or implementation. Moreover, the specific features, structures, materials or characteristics described can be combined in any one or more embodiments or implementations in any suitable manner.

It should be noted that the technical features involved in various embodiments of the present invention described below may be combined with each other as long as they do not conflict with each other.

Embodiments of the present invention provide a current sampling method and device for a power factor correction (PFC) circuit, an air conditioner, and a storage medium. By outputting a turn-on signal to a switching component, the switching component can be turned on, thereby allowing the acquisition of a first duration of the turn-on signal. Based on this first duration, a theoretical sampling time point for performing sampling on the PFC circuit can be determined. Next, a second duration during which the switching component is turned on can be acquired based on the theoretical sampling time point. Then, based on the first duration and the second duration, a compensation duration for performing current sampling on the PFC circuit can be determined. Furthermore, by adjusting the theoretical sampling time point based on the compensation duration, a delay of the turn-on signal passing through the switching component can be compensated, ensuring the consistency between the theoretical sampling time point and the actual sampling time point. Finally, current sampling on the PFC circuit can be performed based on the target sampling time point obtained by adjusting the theoretical sampling time point, ensuring that the actual sampled current is consistent with the expected sampled current, thereby enhancing the accuracy of the sampled current.

The embodiments of the present invention will be further explained below in conjunction with the accompanying drawings.

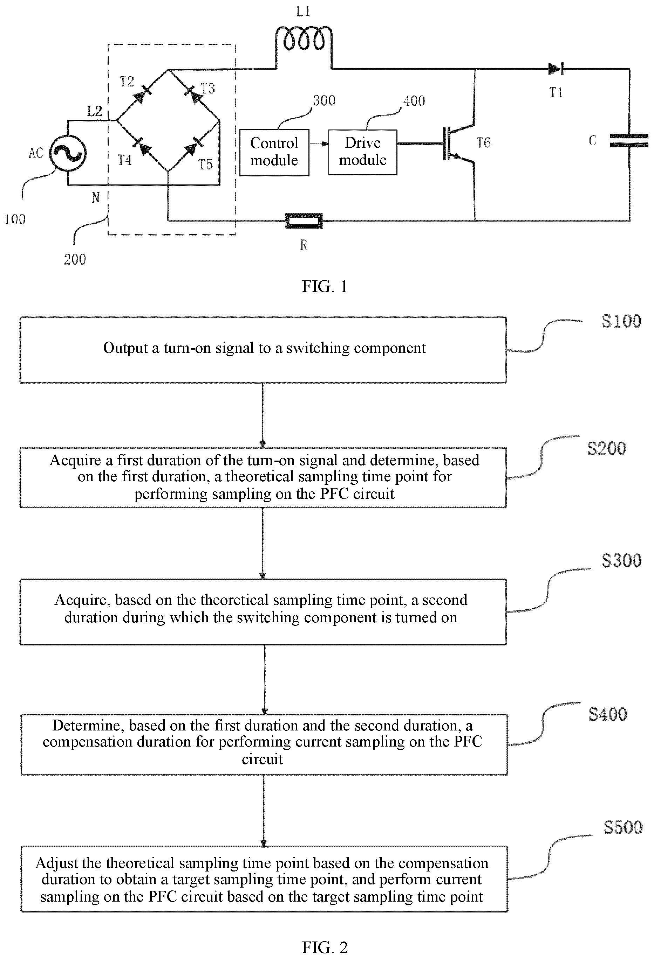

As shown in FIG. 1, FIG. 1 is a schematic diagram of a PFC circuit according to an embodiment of the present invention.

In FIG. 1, the PFC circuit of the embodiment of the present invention may include an AC input terminal 100, a rectifier bridge 200, an inductor component L1, a switching component T6, a sampling resistor R, a control module 300, a drive module 400, a first transistor T1, and a capacitor component C connected in sequence. The switching component T6 includes a first connection terminal, a second connection terminal, and a third connection terminal. The rectifier bridge 200, the inductor component L1, the first transistor T1, the capacitor component C, and the sampling resistor R connected in sequence. The AC input terminal 100 is connected to the rectifier bridge 200. The control module 300, the drive module 400, and the first connection terminal of the switching component T6 are connected in sequence. The second connection terminal of the switching component T6 is connected to the inductor component L1 and the first transistor T1, respectively. The third connection terminal of the switching component T6 is connected to the capacitor component C and the sampling resistor R, respectively.

The AC input terminal 100 may include a third connection terminal which is a live wire terminal L2, and a fourth connection terminal which is a neutral wire terminal N, and both the neutral wire terminal N and the live wire terminal L2 are connected to the rectifier bridge 200. Additionally, the AC input terminal 100 receives AC power, and inputs the AC power into the rectifier bridge 200 through the live wire terminal L2 and the neutral wire terminal N, and the rectifier bridge 200 rectifies the AC power. The embodiment of the present invention does not impose specific limitations on this.

The rectifier bridge 200 may include a second transistor T2, a third transistor T3, a fourth transistor T4, and a fifth transistor T5. The inductor component L1 includes a fifth connection terminal and a sixth connection terminal. The sampling resistor R includes a seventh connection terminal and an eighth connection terminal. A positive terminal of the second transistor T2 is connected to a negative terminal of the fourth transistor T4, and a negative terminal of the second transistor T2 is connected to the fifth connection terminal of the inductor component L1. A positive terminal of the fourth transistor T4 is connected to the seventh connection terminal of the sampling resistor R. A positive terminal of the third transistor T3 is connected to a negative terminal of the fifth transistor T5, and a negative terminal of the third transistor T3 is connected to the fifth connection terminal of the inductor component L1. A positive terminal of the fifth transistor T5 is connected to the seventh connection terminal of the sampling resistor R. Both the positive terminal of the second transistor T2 and the negative terminal of the fourth transistor T4 are connected to the live wire terminal L2, while both the positive terminal of the third transistor T3 and the negative terminal of the fifth transistor T5 are connected to the neutral wire terminal N. Herein, the second transistor T2, the third transistor T3, the fourth transistor T4, and the fifth transistor T5 may all be diodes, and the present embodiment does not impose specific limitations on this.

The second connection terminal of the switching component T6 is connected to the sixth connection terminal of the inductor component L1 and a positive terminal of the first transistor T1, respectively; and the third connection terminal of the switching component T6 is connected to the capacitor component C and the eighth connection terminal of the sampling resistor R, respectively.

In a possible implementation, the switching component T6 may be an insulated gate bipolar transistor (IGBT). The first connection terminal of the switching component T6 may be a gate of the IGBT. The second connection terminal of the switching component T6 may be a drain of the IGBT. The third connection terminal of the switching component T6 may be a source of the IGBT. The embodiment of the present invention does not impose specific limitations on this.

In a possible implementation, the first transistor T1 may be a diode, the capacitor component C may be an electrolytic capacitor, and the control module 300 may be a control chip. The embodiment of the present invention does not impose specific limitations on this.

In a possible implementation, a drive signal output by the control module 300 may be a high-level drive signal or a low-level drive signal. When the drive module 400 receives a high-level drive signal, the drive module 400 can drive the switching component T6 to turn on through the drive signal. The high-level drive signal is the turn-on signal. For example, when the control module 300 is powered, the turn-on signal output by the control module 300 is input to the switching component T6 through the drive module 400, causing the switching component T6 to be in the turn-on state; and when the drive module 400 receives a low-level drive signal, the drive module 400 can drive the switching component T6 to turn off through the drive signal. The embodiment of the present invention does not impose specific limitations on this.

It can be understood that the PFC circuit may be applied in a switching power supply and inverter circuits. Correspondingly, the PFC circuit may be set on the electric control board of the switching power supply, or on the electric control board equipped with the inverter. The embodiment of the present invention does not impose specific limitations on this.

The PFC circuit described in the embodiment of the present invention is to more clearly illustrate the technical scheme of the embodiments of the present invention and does not constitute a limitation on the technical scheme provided by the embodiments of the present invention. Those skilled in the art may understand that with the evolution of the PFC circuit and the emergence of new application scenarios, the technical scheme provided by the embodiments of the present invention is also applicable to similar technical problems.

Those having ordinary skill in the art can understand that the structure of the PFC circuit shown in FIG. 1 does not constitute a limitation on the embodiments of the present invention, and there may be more or fewer components than illustrated, or some components may be combined, or different arrangements of the components may be contemplated.

Based on the structure of the PFC circuit described above, various embodiments of the current sampling method for the PFC circuit of the present invention are proposed.

As shown in FIG. 2, FIG. 2 is a flowchart of a current sampling method of a PFC circuit according to an embodiment of the present invention. The current sampling method of the PFC circuit can be applied to the PFC circuit shown in FIG. 1, and the current sampling method for the PFC circuit includes but is not limited to the following steps.

At a step S100, a turn-on signal is output to a switching component.

In this step, the turn-on signal is the signal that drives the switching component to turn on. This turn-on signal can be a high-level drive signal, for example, a high-level pulse width modulation (PWM) signal, and is not specifically limited here.

At a step S200, a first duration of the turn-on signal is acquired and a theoretical sampling time point for performing sampling on the PFC circuit is determined based on the first duration.

In this step, by outputting the turn-on signal to the switching component, the switching component can be turned on. After the switching component is turned on, the first duration of the turn-on signal can be acquired, and then the theoretical sampling time point for performing sampling on the PFC circuit can be determined based on this first duration, thereby facilitating the subsequent step of acquiring the second duration during the switching component is turned on based on this theoretical sampling time point. The first duration is a duration during which the turn-on signal drives the switching component to turn on within one PFC cycle.

At a step S300, a second duration during which the switching component is turned on is acquired based on the theoretical sampling time point.

In this step, the theoretical sampling time point is a time point that corresponds to half of the first duration during which the switching component is turned on.

It can be understood that there is a delay when the turn-on signal passes through the switching component, which leads to a delay in the switching component turning on. Therefore, the delayed turn-on of the switching component will cause the second duration of the turn-on of the switching component obtained at the theoretical sampling time point to be shorter than half of the first duration.

At a step S400, a compensation duration for performing current sampling on the PFC circuit is determined based on the first duration and the second duration.

In this step, the compensation duration is the time length that compensates for the delay of the turn-on signal passing through the switching component.

At a step S500, the theoretical sampling time point is adjusted based on the compensation duration to obtain a target sampling time point, and current sampling is performed on the PFC circuit based on the target sampling time point.

In an embodiment, the theoretical sampling time point is adjusted based on the compensation duration to obtain the target sampling time point in a following way. For example, the target sampling time point can be achieved by adding the compensation duration to the theoretical sampling time point i.e., the target sampling time point corresponds to the time point obtained by adding the compensation duration to the theoretical sampling time point, without imposing any specific limitations here.

In this embodiment, by outputting the turn-on signal to the switching component, the switching component can be turned on, thereby allowing the acquisition of the first duration of the turn-on signal. Based on this first duration, the theoretical sampling time point for performing sampling on the PFC circuit can be determined. Next, the second duration during which the switching component is turned on can be acquired based on the theoretical sampling time point. Then, based on the first duration and the second duration, the compensation duration for performing current sampling on the PFC circuit can be determined. Furthermore, by adjusting the theoretical sampling time point based on the compensation duration, the delay of the turn-on signal passing through the switching component can be compensated, ensuring the consistency between the theoretical sampling time point and the actual sampling time point. Finally, current sampling on the PFC circuit can be performed based on the target sampling time point obtained by adjusting the theoretical sampling time point, ensuring that the actual sampled current is consistent with the expected sampled current, thereby enhancing the accuracy of the sampled current.

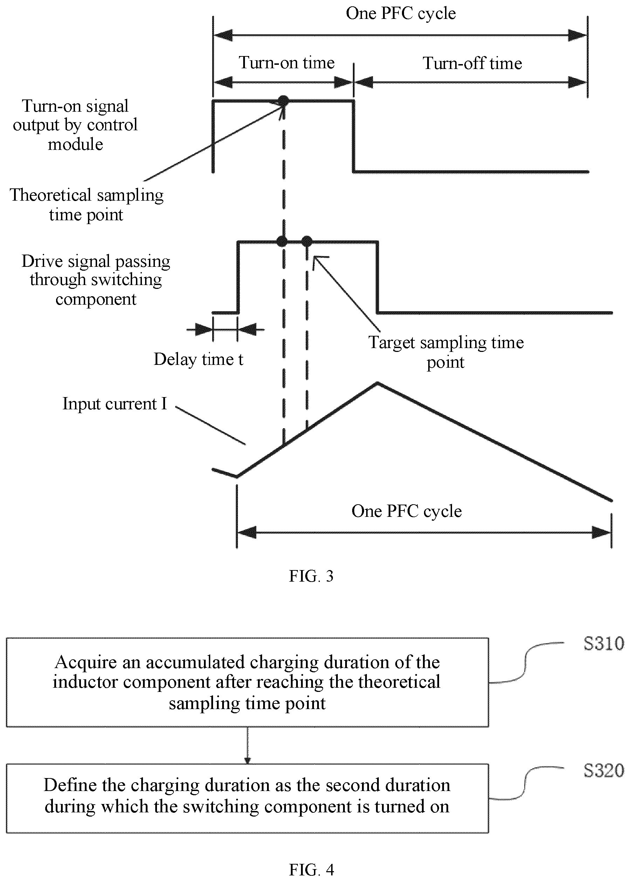

It is worth noting that, as shown in FIG. 3, in the related art, the PFC current sampling point in the PFC circuit is fixed at the midpoint of the turn-on time of the turn-on signal output by the control module, and the theoretical sampling current is a current at the midpoint time point of the turn-on time of the turn-on signal passing through the switching component (i.e., the IGBT turn-on time). Due to the delay that occurs when the turn-on signal output by the control module passes through the drive module (such as an IGBT driver chip), and additionally, due to the fact that there will also be a delay when the turn-on signal passes through the switching component because of the internal resistance of the switching component, a delay is caused in the turn-on of the switching component. The delayed turn-on of the switching component will cause the actual sampled current to be smaller than the theoretical sampled current, leading to an error in the sampled current. Further, the shorter the turn-on time, the greater the current rise slope of the PFC circuit. Therefore, the longer the delay time, the greater the error it causes to the sampled current, which in turn affects the power factor, current harmonics, and current control of the PFC circuit.

To solve the problems existing in the related art, the current sampling method for the PFC circuit in the embodiment of the present invention can compensate for the delay of the turn-on signal passing through the switching component, thereby ensuring the consistency between the theoretical sampling time point and the actual sampling time point. Finally, current sampling on the PFC circuit can be performed based on the target sampling time point obtained from the adjustment of the theoretical sampling time point. This method ensures that the actual sampled current matches the expected sampled current improves the accuracy of the sampled current, solves the inherent delay present in the hardware circuit, ensures stable control of the PFC current, improves the power factor, reduces the harmonics of each current, thereby enhancing the overall transmission efficiency of electric energy.

As shown in FIG. 4, FIG. 4 is a specific flowchart of the step S300 in FIG. 2. In the example of FIG. 4, in the case where the PFC circuit also includes an inductor component and the switching component is configured to control the inductor component for charging and discharging, the step S300 also includes, but is not limited to, a step S310 and a stepS320.

At the step S310, an accumulated charging duration of the inductor component after reaching the theoretical sampling time point is acquired.

At the step S320, the charging duration is defined as the second duration during which the switching component is turned on.

It can be understood that the inductor component can be configured to store electrical energy. When the switching component is turned on, the AC input current passes through the inductor component to charge the inductor component. During the charging process of the inductor component, the current of the inductor component increases. After reaching the theoretical sampling time point, the accumulated charging duration of the inductor component can be obtained, and this charging duration can be defined as the second duration during which the switching component is turned on, facilitating the subsequent step of determining the compensation duration for current sampling on the PFC circuit based on this second duration, thereby compensating for the delay of the turn-on signal passing through the switching component based on the compensation duration to ensure the consistency between the theoretical sampling time point and the actual sampling time point.

It can be understood that the switching component is configured to control the inductor component for discharging, i.e., when the switching component is turned off, the inductor component discharges the AC current which it has stored to charge the capacitor component, with no specific limitations imposed here.

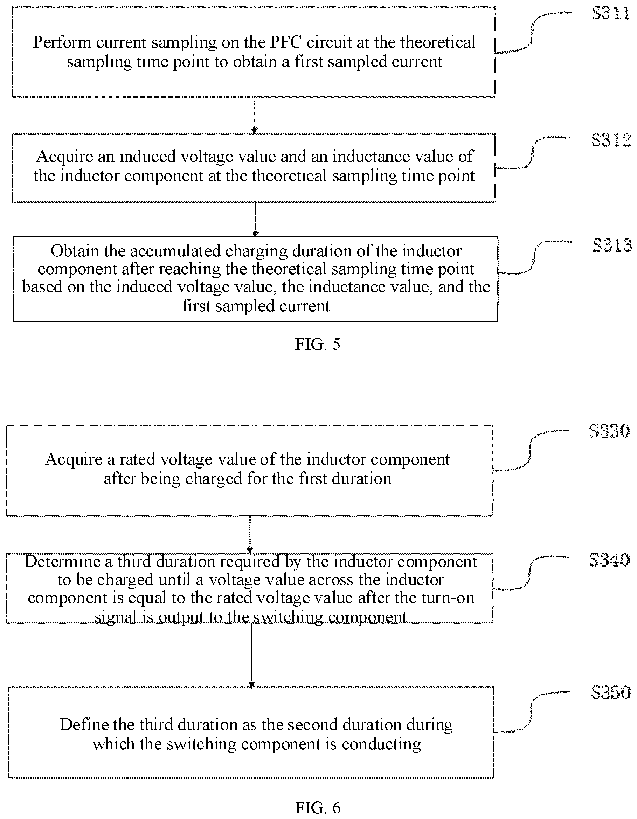

As shown in FIG. 5, FIG. 5 is a specific flowchart of the step S310 in FIG. 4. In the example of FIG. 5, the step S310 also includes, but is not limited to, a step S311, a step S312, and a step S313.

At the step S311, current sampling is performed on the PFC circuit at the theoretical sampling time point to obtain a first sampled current.

In this step, the first sampled current is the actual sampled current.

At the step S312, both an induced voltage value and an inductance value of the inductor component at the theoretical sampling time point are acquired.

In this step, the inductance value of the inductor component may be obtained using an inductance testing instrument such as an impedance tester, an LCR tester, or a digital bridge, with no specific limitations imposed here.

At the step S313, the accumulated charging duration of the inductor component after reaching the theoretical sampling time point is obtained based on the induced voltage value, the inductance value, and the first sampled current.

In an embodiment, the accumulated charging duration of the inductor component after reaching the theoretical sampling time point can be calculated using the following formula:

$$U_i = L \frac{d_i}{d_t}$$

where $U_i$ is the induced voltage value, $L$ is the inductance value, $i$ is the first sampled current, i.e., the actual sampled current, and $t$ is the accumulated charging duration of the inductor component after reaching the theoretical sampling time point.

In this embodiment, due to the delay that occurs when the turn-on signal passes through the switching component, leading to a delay in the turn-on of the switching component, the actual sampled current (i.e., the first sampled current) is smaller than the theoretical sampled current, resulting in an error in the sampled current. Based on this, the current sampling method of the embodiment of the present invention can acquire both the induced voltage value and inductance value of the inductor component at the theoretical sampling time point. Based on the induced voltage value, inductance value, and first sampled current, the accumulated charging duration of the inductor component after reaching the theoretical sampling time point can be obtained, facilitating subsequent steps to determine the compensation duration for current sampling on the PFC circuit based on this charging duration (i.e., the second duration), thereby compensating for the delay of the turn-on signal passing through the switching component to ensure the consistency between the theoretical sampling time point and the actual sampling time point, and improving the accuracy of the sampled current of the PFC circuit.

As shown in FIG. 6, FIG. 6 is another specific flowchart of the step S300 in FIG. 2. In the example of FIG. 6, in the case where the PFC circuit also includes an inductor component and the switching component is configured to control the inductor component for charging and discharging, the step S300 also includes, but is not limited to, a step S330, a step S340, and a step S350.

At the step S330, a rated voltage value of the inductor component after being charged for the first duration is acquired.

At S340, it is determined a third duration required by the inductor component to be charged until a voltage value across the inductor component is equal to the rated voltage value after the turn-on signal is output to the switching component.

At S350, the third duration is defined as the second duration during which the switching component is turned on.

It can be understood that the inductor component can be configured to store electrical energy. After outputting the turn-on signal to the switching component, the switching component can be turned on to allow for the charging of the inductor component. During the charging process of the inductor component, the current of the inductor component increases. When the voltage value across the inductor component equals the rated voltage value, the third duration required by the inductor component to be charged until a voltage value across the inductor component is equal to the rated voltage value can be determined. This third duration can be defined as the second duration during which the switching component is turned on, facilitating subsequent steps to determine the compensation duration for current sampling on the PFC circuit based on this second duration, thereby compensating for the delay of the turn-on signal passing through the switching component based on the compensation duration to ensure the consistency between the theoretical sampling time point and the actual sampling time point.

In this embodiment, due to the delay that occurs when the turn-on signal passes through the switching component, leading to a delay in the turn-on of the switching component, the actual sampled current (i.e., the first sampled current) is smaller than the theoretical sampled current, resulting in an error in the sampled current. Based on this, after the turn-on signal is output to the switching component, the third duration required by the inductor component to be charged until the voltage value across the inductor component is equal to the rated voltage value will be longer than the first duration. Then, this third duration can be defined as the second duration during which the switching component is turned on, facilitating subsequent steps to determine the compensation duration for current sampling on the PFC circuit based on this second duration, thereby compensating for the delay of the turn-on signal passing through the switching component based on the compensation duration to ensure the consistency between the theoretical sampling time point and the actual sampling time point.

Further, if the third duration is defined as the second duration during which the switching component is turned on, then the second duration can be subtracted from the first duration to obtain the compensation duration for current sampling on the PFC circuit, thereby compensating for the delay of the turn-on signal passing through the switching component based on the compensation duration to ensure the consistency between the theoretical sampling time point and the actual sampling time point.

It can be understood that the switching component is configured to control the inductor component for discharging, i.e., when the switching component is turned off, the inductor component discharges the AC current which it has stored to charge the capacitor component, with no specific limitations imposed here.

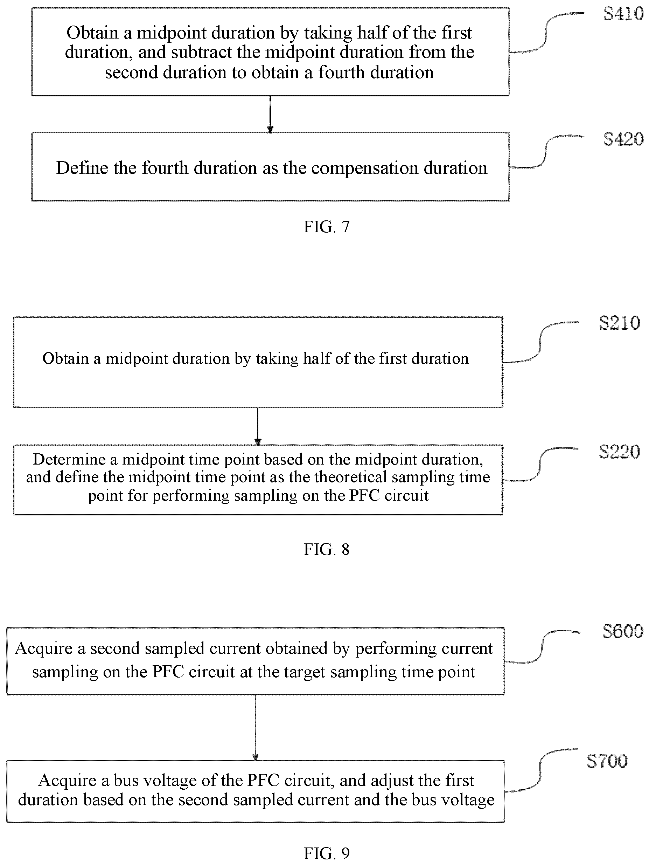

As shown in FIG. 7, FIG. 7 is a specific flowchart of the step S400 in FIG. 2. In the example of FIG. 7, the step S400 further includes, but is not limited to, a step S410 and a step S420.

At the step S410, a midpoint duration is obtained by taking half of the first duration, and the midpoint duration is subtracted from the second duration to obtain a fourth duration.

At the step S420, the fourth duration is defined as the compensation duration.

In this embodiment, by subtracting half of the first duration (namely the midpoint duration) from the second duration, the compensation duration can be obtained, thereby allowing for compensation for the delay of the turn-on signal passing through the switching component based on the compensation duration, ensuring the consistency between the theoretical sampling time point and the actual sampling time point, and improving the accuracy of the sampled current in the PFC circuit.

It can be understood that when the second duration is an accumulated charging duration of the inductor component after the theoretical sampling time point is reached, a midpoint duration can be obtained by taking half of the first duration. The midpoint duration is then subtracted from the second duration to obtain a fourth duration, which will be defined as the compensation duration, without any specific limitations imposed here.

As shown in FIG. 8, FIG. 8 is a specific flowchart of the step S200 in FIG. 2. In the example of FIG. 8, the step S200 further includes, but is not limited to, a step S210 and a step S220.

At the step S210, a midpoint duration is obtained by taking half of the first duration.

At the step S220, a midpoint time point is determined based on the midpoint duration, and the midpoint time point is defined as the theoretical sampling time point for performing sampling on the PFC circuit.

It can be understood that the midpoint time point is determined based on half of the first duration, and the theoretical sampling time point for performing sampling on the PFC circuit is defined based on this midpoint time point, i.e., within one PFC cycle, the midpoint time point corresponding to half of a duration that the turn-on signal drives the switching component to turn on is the theoretical sampling time point.

In this embodiment, by determining the midpoint time point based on half of the first duration, the theoretical sampling time point for performing sampling on the PFC circuit can be determined based on the midpoint time point, facilitating the subsequent step of acquiring the second duration during which the switching component is turned on based on the theoretical sampling time point. This allows for the determination of the compensation duration for performing current sampling on the PFC circuit based on the second duration, and the compensating for the delay of the turn-on signal passing through the switching component, thereby ensuring the consistency between the theoretical sampling time point and the actual sampling time point, and enhancing the accuracy of the sampled current.

As shown in FIG. 9, FIG. 9 is a flowchart of a current sampling method of a PFC circuit according to an embodiment of the present invention. After executing the step S500, the current sampling method of the PFC circuit may also include, but is not limited to, a step S600 and a step S700.

At the step S600, a second sampled current obtained is acquired by performing current sampling on the PFC circuit at the target sampling time point.

In this step, the target sampling time point corresponds to a time point that is half of the second duration during which the switching component is turned on. Therefore, the second sampled current obtained at the time point corresponding to half of the second duration during which the switching component is turned on is equal to the sampled current of the theoretical sampling. Thus, this step can ensure that the actual sampled current is consistent with the expected sampled current.

At the step S700, a bus voltage of the PFC circuit is acquired, and the first duration is adjusted based on the second sampled current and the bus voltage.

In this embodiment, by adjusting the theoretical sampling time point and performing current sampling on the PFC circuit based on the adjusted theoretical sampling time point, the second sampled current can be obtained by performing current sampling on the PFC circuit at the target sampling time point, i.e., the actual sampled current is equal to the theoretical sampled current. Then, by acquiring the bus voltage of the PFC circuit, the first duration can be adjusted based on the second sampled current and the bus voltage, thereby ensuring that all subsequent sampled currents are consistent with the expected sampled current. Therefore, the embodiment of the present invention can enhance the accuracy of the sampled current.

For the current sampling method provided in the above embodiments, the current waveform of the second sampled current is compared with the current waveform of the first sampled current with specific examples.

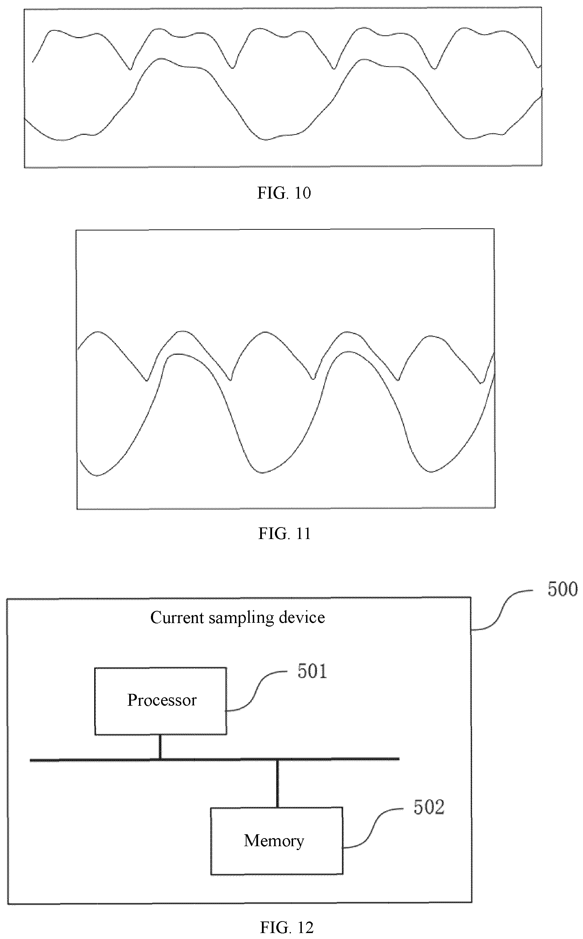

As shown in FIG. 10, the current waveforms of the sampled currents in the related art shown in FIG. 10 have errors due to the delayed turn-on of the switching component. That is, the current waveform of the first sampled current is obtained by performing current sampling on the PFC circuit before the theoretical sampling time point is adjusted. The current waveform located at the upper portion of the figure is a current waveform of the inductor current at the inductor component, and the current waveform located at the lower portion of the figure is a current waveform of the live wire current at the live wire terminal. As can be seen from FIG. 7, a peak of the inductor current is concave, and a peak of the live wire current is also concave.

As shown in FIG. 11, the current waveforms of the sampled currents obtained after executing the current sampling method are shown in FIG. 11. That is, after the theoretical sampling time point is adjusted, the current waveform of the second sampled current is obtained by performing current sampling on the PFC circuit at the target sampling time point. The current waveform located at the upper portion of the figure is the current waveform of the inductor current at the inductor component, and the current waveform located at the lower portion of the figure is the current waveform of the live wire current at the live wire terminal. As can be seen from FIG. 8, the waveform of the inductor current is regular and undistorted, and the waveform of the line current is also regular and undistorted.

In summary, the current sampling method for the PFC circuit according to the embodiment of the present invention can automatically calibrate the sampling time point, ensure stable control of the PFC current, and enhance the accuracy of the sampled current.

As shown in FIG. 12, an embodiment of the second aspect of the present invention provides a current sampling device 500, including a memory 502, a processor 501, and a computer program stored in the memory 502 that can be executed by the processor 501. The processor 501 and the memory 502 can be connected via a bus or other means. In FIG. 12, an example of connection via a bus is shown. The processor 501 executes the aforementioned computer program to implement the current sampling method of the first aspect of the embodiment described above, for example, to implement the steps S100 to S500 in FIG. 2, the steps S310 and S320 in FIG. 4, the steps S311 to S313 in FIG. 5, the steps S330 to S350 in FIG. 6, the steps S410 to S420 in FIG. 7, the steps S210 to S220 in FIG. 8, and the steps S600 to S700 in FIG. 9. By outputting the turn-on signal to the switching component, the switching component can be turned on, thereby allowing the acquisition of the first duration of the turn-on signal. Based on this first duration, the theoretical sampling time point for performing sampling on the PFC circuit can be determined. Next, the second duration during which the switching component is turned on can be acquired based on the theoretical sampling time point. Then, based on the first duration and the second duration, the compensation duration for performing current sampling on the PFC circuit can be determined. Furthermore, by adjusting the theoretical sampling time point based on the compensation duration, the delay of the turn-on signal passing through the switching component can be compensated, ensuring the consistency between the theoretical sampling time point and the actual sampling time point. Finally, current sampling on the PFC circuit can be performed based on the target sampling time point obtained by adjusting the theoretical sampling time point, ensuring that the actual sampled current is consistent with the expected sampled current, thereby enhancing the accuracy of the sampled current.

An embodiment of the third aspect of the present invention provides an air conditioner, which includes the current sampling device as described in the second aspect. By outputting the turn-on signal to the switching component, the switching component can be turned on, thereby allowing the acquisition of the first duration of the turn-on signal. Based on this first duration, the theoretical sampling time point for performing sampling on the PFC circuit can be determined. Next, the second duration during which the switching component is turned on can be acquired based on the theoretical sampling time point. Then, based on the first duration and the second duration, the compensation duration for performing current sampling on the PFC circuit can be determined. Furthermore, by adjusting the theoretical sampling time point based on the compensation duration, the delay of the turn-on signal passing through the switching component can be compensated, ensuring the consistency between the theoretical sampling time point and the actual sampling time point. Finally, current sampling on the PFC circuit can be performed based on the target sampling time point obtained by adjusting the theoretical sampling time point, ensuring that the actual sampled current is consistent with the expected sampled current, thereby enhancing the accuracy of the sampled current.

According to an embodiment of the fourth aspect of the present invention, a computer-readable storage medium stores computer-executable instructions that can be configured to cause a computer to perform the current sampling method of the first aspect of the embodiment described above, for example, to execute the steps S100 to S500 in FIG. 2, the steps S310 and the step S320 in FIG. 4, the steps S311 to S313 in FIG. 5, the steps S330 to S350 in FIG. 6, the steps S410 to S420 in FIG. 7, the steps S210 to S220 in FIG. 8, and the steps S600 to S700 in FIG. 9. By outputting the turn-on signal to the switching component, the switching component can be turned on, thereby allowing the acquisition of the first duration of the turn-on signal. Based on this first duration, the theoretical sampling time point for performing sampling on the PFC circuit can be determined. Next, the second duration during which the switching component is turned on can be acquired based on the theoretical sampling time point. Then, based on the first duration and the second duration, the compensation duration for performing current sampling on the PFC circuit can be determined. Furthermore, by adjusting the theoretical sampling time point based on the compensation duration, the delay of the turn-on signal passing through the switching component can be compensated, ensuring the consistency between the theoretical sampling time point and the actual sampling time point. Finally, current sampling on the PFC circuit can be performed based on the target sampling time point obtained by adjusting the theoretical sampling time point, ensuring that the actual sampled current is consistent with the expected sampled current, thereby enhancing the accuracy of the sampled current.

It can be understood by those of ordinary skill in the art that all or some of the steps of the methods and systems disclosed above may be implemented as software, firmware, hardware, and appropriate combinations thereof. Some or all of the physical components may be implemented as software executed by a processor, such as a central processing unit, a digital signal processor or a microprocessor, or as hardware, or as an integrated circuit, such as an application-specific integrated circuit. Such software may be distributed on a computer-readable media, which may include computer-readable storage media or non-transitory media and communication media or transitory media. As well known to those of ordinary skill in the art, the term computer-readable storage medium includes volatile and nonvolatile, removable and non-removable media implemented in any method or technique for storing information, such as computer-readable instructions, data structures, program modules or other data. A computer-readable storage medium includes but is not limited to RAM, ROM, EEPROM, flash memory or other memory technologies, CD-ROM, digital versatile disk (DVD) or other optical disk storage, cassettes, magnetic tapes, magnetic disk storage or other magnetic storage devices, or any other medium that can be configured to store desired information and can be accessed by a computer. Furthermore, it is well known to those of ordinary skill in the art that communication media typically contain computer-readable instructions, data structures, program modules or other data in a modulated data signal such as a carrier wave or other transmission mechanism, and may include any information transmission media.

Although the embodiments of the present invention have been described in detail above with reference to the accompanying drawings, the present invention is not limited to the above embodiments, and various changes may be made within the knowledge of those of ordinary skill in the art without departing from the purpose of the present invention.

## Claims

1. A current sampling method for a power factor correction, PFC, circuit which comprises a switching component, the method comprising:

   outputting a turn-on signal to the switching component;
   acquiring a first duration of the turn-on signal and determining, based on the first duration, a theoretical sampling time point for performing sampling on the PFC circuit;
   acquiring, based on the theoretical sampling time point, a second duration during which the switching component is turned on;
   determining, based on the first duration and the second duration, a compensation duration for performing current sampling on the PFC circuit; and
   adjusting the theoretical sampling time point based on the compensation duration to obtain a target sampling time point, and performing current sampling on the PFC circuit based on the target sampling time point.

2. The current sampling method of claim 1, wherein:

   the PFC circuit further comprises an inductor component configured to control charging and discharging of the inductor component; and
   said acquiring, based on the theoretical sampling time point, a second duration during which the switching component is turned on comprises:

      acquiring an accumulated charging duration of the inductor component after the theoretical sampling time point is reached; and
      defining the accumulated charging duration as the second duration during which the switching component is turned on.

3. The current sampling method of claim 2, wherein said acquiring an accumulated charging duration of the inductor component after the theoretical sampling time point is reached comprises:

   performing current sampling on the PFC circuit at the theoretical sampling time point to obtain a first sampled current;
   acquiring both an induced voltage value and an inductance value of the inductor component at the theoretical sampling time point; and
   obtaining the accumulated charging duration of the inductor component after the theoretical sampling time point is reached based on the induced voltage value, the inductance value, and the first sampled current.

4. The current sampling method of claim 1, wherein:

   the PFC circuit further comprises an inductor component configured to control charging and discharging of the inductor component; and
   said acquiring, based on the theoretical sampling time point, a second duration during which the switching component is turned on comprises:

      acquiring a rated voltage value of the inductor component after the inductor component is charged for the first duration;
      determining a third duration required by the inductor component to be charged until a voltage value across the inductor component is equal to the rated voltage value after the turn-on signal is output to the switching component; and

defining the third duration as the second duration during which the switching component is turned on.

5. The current sampling method of claim 1, wherein said determining, based on the first duration and the second duration, a compensation duration for performing current sampling on the PFC circuit comprises:

obtaining a midpoint duration by taking half of the first duration, and subtracting the midpoint duration from the second duration to obtain a fourth duration; and
defining the fourth duration as the compensation duration.

6. The current sampling method of claim 1, wherein said adjusting the theoretical sampling time point based on the compensation duration to obtain a target sampling time point comprises:
obtaining the target sampling time point based on a sum of the compensation duration and the theoretical sampling time point.

7. The current sampling method of claim 1, wherein said determining, based on the first duration, a theoretical sampling time point for performing sampling on the PFC circuit comprises:

obtaining a midpoint duration by taking half of the first duration; and
determining a midpoint time point based on the midpoint duration, and defining the midpoint time point as the theoretical sampling time point for performing sampling on the PFC circuit.

8. The current sampling method of claim 1, wherein the method further comprises after performing current sampling on the PFC circuit based on the target sampling time point:

acquiring a second sampled current obtained by performing current sampling on the PFC circuit at the target sampling time point; and
acquiring a bus voltage of the PFC circuit, and adjusting the first duration based on the second sampled current and the bus voltage.

9. A current sampling device, comprising a memory, a processor, and a computer program stored in the memory and executable by the processor, wherein the program, when executed by the processor, causes the processor to implement the current sampling method of any one of claims 1 to 8.

10. An air conditioner, comprising the current sampling device of claim 9.

11. A computer-readable storage medium storing computer-executable instructions, wherein the computer-executable instructions are configured to cause a computer to perform the current sampling method of any one of claims 1 to 8.

FIG. 1

| | S100 |
| Output a turn-on signal to a switching component | |

| | S200 |
| Acquire a first duration of the turn-on signal and determine, based on the first duration, a theoretical sampling time point for performing sampling on the PFC circuit | |

| | S300 |
| Acquire, based on the theoretical sampling time point, a second duration during which the switching component is turned on | |

| | S400 |
| Determine, based on the first duration and the second duration, a compensation duration for performing current sampling on the PFC circuit | |

| | S500 |
| Adjust the theoretical sampling time point based on the compensation duration to obtain a target sampling time point, and perform current sampling on the PFC circuit based on the target sampling time point | |

FIG. 2

One PFC cycle

Turn-on time          Turn-off time

Turn-on signal
output by control
module

Theoretical sampling
time point

Drive signal passing
through switching
component

Delay time t          Target sampling time
point

Input current I

One PFC cycle

FIG. 3

| Acquire an accumulated charging duration of the inductor component after reaching the theoretical sampling time point | S310 |
| Define the charging duration as the second duration during which the switching component is turned on | S320 |

FIG. 4

Perform current sampling on the PFC circuit at the theoretical sampling time point to obtain a first sampled current S311

Acquire an induced voltage value and an inductance value of the inductor component at the theoretical sampling time point S312

Obtain the accumulated charging duration of the inductor component after reaching the theoretical sampling time point based on the induced voltage value, the inductance value, and the first sampled current S313

FIG. 5

Acquire a rated voltage value of the inductor component after being charged for the first duration S330

Determine a third duration required by the inductor component to be charged until a voltage value across the inductor component is equal to the rated voltage value after the turn-on signal is output to the switching component S340

Define the third duration as the second duration during which the switching component is conducting S350

FIG. 6

Obtain a midpoint duration by taking half of the first duration, and subtract the midpoint duration from the second duration to obtain a fourth duration

S410

Define the fourth duration as the compensation duration

S420

FIG. 7

Obtain a midpoint duration by taking half of the first duration

S210

Determine a midpoint time point based on the midpoint duration, and define the midpoint time point as the theoretical sampling time point for performing sampling on the PFC circuit

S220

FIG. 8

Acquire a second sampled current obtained by performing current sampling on the PFC circuit at the target sampling time point

S600

Acquire a bus voltage of the PFC circuit, and adjust the first duration based on the second sampled current and the bus voltage

S700

FIG. 9

FIG. 10

FIG. 11

FIG. 12

## INTERNATIONAL SEARCH REPORT

| | |
|---|---|
| International application No. |
| **PCT/CN2023/085159** |

**A.    CLASSIFICATION OF SUBJECT MATTER**

H02M1/42(2007.01)i;  G01R19/00(2006.01)i

According to International Patent Classification (IPC) or to both national classification and IPC

**B.    FIELDS SEARCHED**

Minimum documentation searched (classification system followed by classification symbols)

IPC: H02M, G01R

Documentation searched other than minimum documentation to the extent that such documents are included in the fields searched

Electronic data base consulted during the international search (name of data base and, where practicable, search terms used)

CNTXT, ENTXT, ENTXTC, DWPI, CNKI: 电流, 采集, 采样, 延迟, 延后, 延时, 时延, 滞后, 迟滞, 时间, 时长, 时刻, 补偿, 校正, 调整, 调节, current, sample, detect, delay, lag, late, time, timing, compensate, correct, adjust

**C.    DOCUMENTS CONSIDERED TO BE RELEVANT**

| Category* | Citation of document, with indication, where appropriate, of the relevant passages | Relevant to claim No. |
|---|---|---|
| A | US 2008238374 A1 (DELTA ELECTRONICS, INC.) 02 October 2008 (2008-10-02)<br>entire document | 1-11 |
| A | CN 113809912 A (ZHUHAI TUOXIN TECHNOLOGY CO., LTD. et al.) 17 December 2021 (2021-12-17)<br>entire document | 1-11 |
| A | CN 105790607 A (NINGBO AISA MICROELECTRONICS TECHNOLOGY CO., LTD.) 20 July 2016 (2016-07-20)<br>entire document | 1-11 |
| A | JP 2011109884 A (TOYOTA MOTOR CORP.) 02 June 2011 (2011-06-02)<br>entire document | 1-11 |
| A | 蔡逢煌 等 (CAI, Fenghuang et al.). "单相并网逆变器并网电流的过采样技术 (Multisampling Technique of Current in Single-phase Grid-connected Inverter)"<br>电力电子技术 (Power Electronics), Vol. 49, No. 2, 28 February 2015 (2015-02-28), 62-65<br>ISSN: 1000-100X,<br>pages 62-65 | 1-11 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **19 July 2023** | **24 July 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/085159**

| Patent document cited in search report | | | Publication date (day/month/year) | Patent family member(s) | | | Publication date (day/month/year) |
|---|---|---|---|---|---|---|---|
| US | 2008238374 | A1 | 02 October 2008 | US | 7729140 | B2 | 01 June 2010 |
| CN | 113809912 | A | 17 December 2021 | None | | | |
| CN | 105790607 | A | 20 July 2016 | None | | | |
| JP | 2011109884 | A | 02 June 2011 | None | | | |

Form PCT/ISA/210 (patent family annex) (July 2022)

**EP 4 625 798 A1**

## REFERENCES CITED IN THE DESCRIPTION

**Patent documents cited in the description**

- CN 202211466215